# EUROPEAN PATENT APPLICATION

(11) **EP 3 142 111 A1**
(43) Date of publication of application: **15.03.2017**
(21) Application number: 16187721.2
(22) Date of filing: 08.09.2016
(51) Int. Cl.: G10L 25/48, H03G 5/16, H03G 5/24, G10L 25/30, G10L 25/39

(54) **APPARATUS AND METHOD FOR CONTROLLING PLAYBACK OF AUDIO SIGNALS, AND APPARATUS AND METHOD FOR TRAINING A GENRE RECOGNITION MODEL**

(30) Priority: 09.09.2015 KR 20150127913
(71) Applicant: Samsung Electronics Co., Ltd., Suwon-si, Gyeonggi-do 16677 (KR)
(72) Inventor: SEO, Young Wan, Seoul (KR); KIM, Chang Hyun, Gyeonggi-do (KR); SHIM, Eun Soo, Gyeonggi-do (KR)
(74) Representative: Grünecker Patent- und Rechtsanwälte PartG mbB

(57) **Abstract**

Provided is an apparatus and corresponding method to control sound. The apparatus includes a genre determiner configured to determine a genre of sound data by using a genre recognition model, an equalizer setter configured to set an equalizer according to the determined genre, and a reproducer configured to reproduce the sound data based on the set equalizer.

## Description

### BACKGROUND

### 1. Field

The following description relates generally to sound controlling technology, and more particularly to an apparatus and method to control sound and an apparatus and method to train a genre recognition model.

### 2. Description of Related Art

Currently, there are various electronic devices that receive sound data as file data or streaming data, and reproduce the received sound data. Such device has an equalizer that adjusts the quality or tone of sound based on features or signal characteristics of the sound data, and users listen to the sound data by using the equalizer according to their personal preferences.

However, when users use the equalizer to listen to the sound data, it is cumbersome for users to manually change the setting of the equalizer according to the features or the signal characteristics of the sound data.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

Provided are an apparatus and method to control sound, and an apparatus and method to train a genre recognition model.

In accordance with an embodiment, there is provided an apparatus to control sound, the apparatus including: a genre determiner configured to determine a genre of sound data by using a genre recognition model; an equalizer setter configured to set an equalizer according to the determined genre; and a reproducer configured to reproduce the sound data based on the set equalizer.

The genre determiner may determine a program genre of the sound data by using the genre recognition model, and in response to a determination that the sound data is music data, the genre determiner determines a music genre of the sound data.

The program genre may include at least one of news, drama, entertainment, sport, documentaries, movie, comedy, and music.

The music genre may include at least one of classical, dance, folk, heavy metal, hip hop, jazz, pop, rock, Latin, ballad, and rap.

The genre recognition model may be generated by machine learning based on training sound data.

The machine learning algorithm may include one of neural network, decision tree, generic algorithm (GA), genetic programming (GP), Gaussian process regression, Linear Discriminant Analysis, K-nearest Neighbor (K-NN), Perceptron, Radial Basis Function Network, Support Vector Machine (SVM), and deep-learning.

The genre determiner may determine the genre of the sound data partially based on the entire sound data.

The apparatus may further include: a genre change determiner configured to determine whether the genre is changed, by analyzing, in advance, data to be reproduced while the sound data is reproduced.

In response to a determination that the genre has changed, the genre determiner re-determines the genre of the sound data based on the data to be reproduced.

The apparatus may further include: an ambient noise collector configured to collect ambient noise from an environment where the sound data is reproduced; an ambient noise analyzer configured to analyze the collected ambient noise; and an equalizer adjuster configured to adjust the set equalizer based on the analysis.

The equalizer adjuster may adjust the set equalizer to minimize an effect of the collected ambient noise.

In accordance with an embodiment, there is provided a method of controlling sound, the method including: determining a genre of sound data by using a genre recognition model; setting an equalizer according to the determined genre; and reproducing the sound data based on the set equalizer.

The determining of the genre may include determining a program genre of the sound data, and determining a music genre of the sound data in response to a determination that the sound data is music data.

The program genre may include at least one of news, drama, entertainment, sport, documentaries, movie, comedy, and music.

The music genre may include at least one of classical, dance, folk, heavy metal, hip hop, jazz, pop, rock, Latin, ballad, and rap.

The genre recognition model may be generated by machine learning based on training sound data.

The machine learning algorithm may include one of neural network, decision tree, generic algorithm (GA), genetic programming (GP), Gaussian process regression, Linear Discriminant Analysis, K-nearest Neighbor (K-NN), Perceptron, Radial Basis Function Network, Support Vector Machine (SVM), and deep-learning.

The determining of the genre may include determining the genre of the sound data partially based on the entire sound data.

The method may further include: determining whether the genre has changed by analyzing in advance data to be reproduced while the sound data is reproduced.

The method may further include: re-determining the genre of the sound data based on the data to be reproduced, in response to the determination that the genre has changed.

The method may further include: collecting ambient noise from an environment where the sound data is reproduced; analyzing the collected ambient noise; and adjusting the set equalizer based on the analysis.

The adjusting of the set equalizer may include adjusting the set equalizer to minimize an effect of the collected ambient noise.

In accordance with an embodiment, there is provided a non-transitory computer-readable storage medium storing instructions that, when executed by a processor, cause the processor to perform the method described above.

In accordance with another embodiment, there is provided an apparatus to train a genre recognition model, the apparatus including: a collector configured to collect training sound data, which are classified according to a program genre and a music genre; and a trainer configured to train the genre recognition model based on the collected training sound data.

The program genre may include at least one of news, drama, entertainment, sport, documentaries, movie, comedy, and music.

The music genre may include at least one of classical, dance, folk, heavy metal, hip hop, jazz, pop, rock, Latin, ballad, and rap.

A learning algorithm may include one of neural network, decision tree, generic algorithm (GA), genetic programming (GP), Gaussian process regression, Linear Discriminant Analysis, K-nearest Neighbor (K-NN), Perceptron, Radial Basis Function Network, Support Vector Machine (SVM), and deep-learning.

In accordance with another embodiment, there is provided a method to train a genre recognition model on sound data for a sound controlling apparatus, the method including: collecting training sound data, which are classified according to a program genre and a music genre; and training the genre recognition model based on the collected training sound data.

The program genre may include at least one of news, drama, entertainment, sport, documentaries, movie, comedy, and music.

The music genre may include at least one of classical, dance, folk, heavy metal, hip hop, jazz, pop, rock, Latin, ballad, and rap.

A learning algorithm may include one of neural network, decision tree, generic algorithm (GA), genetic programming (GP), Gaussian process regression, Linear Discriminant Analysis, K-nearest Neighbor (K-NN), Perceptron, Radial Basis Function Network, Support Vector Machine (SVM), and deep-learning.

In accordance with an embodiment, there is provided a non-transitory computer-readable storage medium storing instructions that, when executed by a processor, cause the processor to perform the method described above.

In accordance with a further embodiment, there is provided an apparatus, including: a genre determiner configured to determine a genre of input sound data by analyzing metadata of the sound data or by using a genre recognition model to determine either one or both of a program genre of the sound data and, in response to the sound data being music data, a music genre of the sound data; an equalizer setter configured to process a mapping table that maps the genre of the sound data to a preset setting to set an equalizer; and a reproducer configured to reproduce the sound data.

The program genre may include at least one of news, drama, entertainment, sport, documentaries, movie, comedy, and music, and the music genre may include at least one of classical, dance, folk, heavy metal, hip hop, jazz, pop, rock, Latin, ballad, and rap.

The genre determiner may determine the genre of the sound data in real time.

The metadata may include content properties of the sound data including information on location and details of contents, information on a content writer, or information on genre of contents.

The genre determiner may determine either the one or both of the program genre and the music genre independently and sequentially, or simultaneously.

The apparatus may be configured to increase Signal to Noise Ratio (SNR) in the entire frequency range.

The apparatus may further include: an ambient noise collector configured to collect ambient noise from an environment where the sound data is reproduced, an ambient noise analyzer configured to analyze the collected ambient noise, and an equalizer controller configured to adjust the setting of the equalizer based on a result of the analysis performed by the ambient noise analyzer to minimize an effect of ambient noise.

The apparatus may further include: a genre change determiner configured to determine whether a genre has changed by analyzing, in advance, data to be reproduced while the sound data is reproduced and, upon analyzing a frequency component of the data to be reproduced while the sound data is reproduced, determine that a genre has changed in response to a specific frequency component being changed to a level above a predetermined threshold.

Other features and aspects will be apparent from the following detailed description, the drawings, and the claims.

### BRIEF DESCRIPTION OF DRAWINGS

FIG. 1 is a block diagram illustrating an example of an apparatus to control sound, according to an embodiment.
FIG. 2 is a block diagram illustrating an example of a genre determiner illustrated in FIG.1.
FIG. 3 is a block diagram illustrating another example of an apparatus to control sound, according to an embodiment.
FIG. 4 is a block diagram illustrating an example of an apparatus to train a genre recognition model on sound data, according to an embodiment.
FIG. 5 is a flowchart illustrating an example of a method to control sound, according to another exemplary embodiment.
FIG. 6 is a flowchart illustrating another example of a method to control sound according to another embodiment.
FIG. 7 is a flowchart illustrating yet another example of a method to control sound, according to another embodiment.
FIG. 8 is a block diagram illustrating an example of a method to train a genre recognition model on sound data, according to an embodiment.

Throughout the drawings and the detailed description, unless otherwise described, the same drawing reference numerals will be understood to refer to the same elements, features, and structures. The relative size and depiction of these elements may be exaggerated for clarity, illustration, and convenience.

### DETAILED DESCRIPTION

The following description is provided to assist the reader in gaining a comprehensive understanding of the methods, apparatuses, and/or systems described herein. In the following description, a detailed description of known functions and configurations incorporated herein will be omitted when it may obscure the subject matter of the present invention. Further, the terms used throughout this specification are defined in consideration of the functions according to exemplary embodiments, and can be varied according to a purpose of a user or manager, or precedent and so on. Therefore, definitions of the terms should be made on the basis of the overall context.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Throughout the specification, when an element, such as a layer, region, or substrate, is described as being "on," "connected to," or "coupled to" another element, it may be directly "on," "connected to," or "coupled to" the other element, or there may be one or more other elements intervening therebetween. In contrast, when an element is described as being "directly on," "directly connected to," or "directly coupled to" another element, there can be no other elements intervening therebetween.

The terminology used herein is for describing various examples only, and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Due to manufacturing techniques and/or tolerances, variations of the shapes shown in the drawings may occur. Thus, the examples described herein are not limited to the specific shapes shown in the drawings, but include changes in shape that occur during manufacturing.

As used herein, the term "and/or" includes any one and any combination of any two or more of the associated listed items.

The features of the examples described herein may be combined in various ways as will be apparent after an understanding of the disclosure of this application. Further, although the examples described herein have a variety of configurations, other configurations are possible as will be apparent after an understanding of the disclosure of this application.

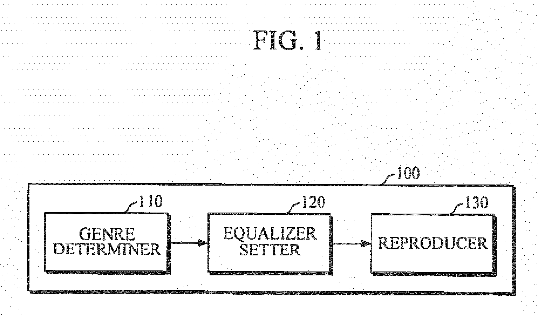

FIG. 1 is a block diagram illustrating an example of an apparatus to control sound, according to an embodiment.

The apparatus to control sound (hereinafter referred to as a "sound controlling apparatus") is a hardware apparatus that automatically adjusts the setting of an equalizer according to a genre of a sound, dialogue, or music, and may be mounted on various types of sound reproducing apparatuses, including a mobile terminal and a fixed terminal. Examples of the mobile terminal may include a cellular phone, a smartphone, a tablet PC, a laptop computer, a digital broadcasting terminal, a personal digital assistant (PDA), a portable multimedia player (PMP), a navigation, and the like, and examples of the fixed terminal may include a digital TV, a smart TV, a desktop computer, and other similar electronic devices.

Referring to FIG. 1, the sound controlling apparatus 100 includes the following structural devices: a genre determiner 110, an equalizer setter 120, and a reproducer 130. Although the sound controlling apparatus 100 is described and illustrated in FIG. 1 as including all three structural devices, additional structural devices may be also included within the sound controlling apparatus 100, such as a display or a processor. Furthermore, in an alternative embodiment, the genre determiner 110 and/or the reproducer 130 may be external to the sound controlling apparatus 100.

The genre determiner 110 is a structural processor configured to determine the genre of input sound data.

In an embodiment, the genre determiner 110 determines the genre of the sound data by analyzing metadata related to or of the sound data. The metadata is data that provides information about content properties of the sound data including, but not limited to, various types of information on the location and details of contents, information on a content writer, or information on the genre of contents. Accordingly, in the case where metadata related to the sound data is input along with the sound data, the genre determiner 110 determines the genre of the sound data by analyzing the metadata.

In another example, the genre determiner 110 determines the genre of the sound data by using a genre recognition model.

For example, the genre determiner 110 determines the genre of the sound data by analyzing metadata related to the sound data or by using a genre recognition model that determines, in an example in which the sound data is music data, a music genre of the sound data. Examples of the program genre may include, but are not limited to, news, drama, entertainment, sport, documentaries, movie, comedy, and/or music, and examples of the music genre may include, but are not limited to, classical, dance, folk, heavy metal, hip hop, jazz, pop, rock, Latin, ballad, and/or rap.

The genre recognition model may be pre-generated by machine learning based on a plurality of training sound data or by using a rule-base machine learning algorithm using hand-craft features. Examples of the machine learning algorithm may include, but are not limited to, neural network, decision tree, generic algorithm (GA), genetic programming (GP), Gaussian process regression, Linear Discriminant Analysis, K-nearest Neighbor (K-NN), Perceptron, Radial Basis Function Network, Support Vector Machine (SVM), and deep-learning.

The genre determiner 110 determines the genre of sound data in real time, based in part on, using, or processing the entire sound data in response to an instruction to reproduce the sound data.

For example, assuming that the sound data is file data or streaming data, the sound controlling apparatus 100 receives an instruction to reproduce the sound data, and the genre determiner 110 determines the genre of the sound data based on the initial five-second part of the entire sound data. Although the initial five seconds is used to determine the genre, other amounts of time may be used, such as less than five seconds or more than five seconds, to determine the genre of the sound data.

The equalizer setter 120 is a processor or a controller configured to set an equalizer according to the genre of the sound data determined by the genre determiner 110. In an embodiment, the equalizer setter 120 sets the equalizer by using a table for mapping the genre to the preset setting of the equalizer (hereinafter referred to as a mapping table).

Table 1 below shows an example of the mapping table.

**[Table 1]**

| Genre | Setting of equalizer |
|---|---|
| News | Setting 1 |
| Drama | Setting 2 |
| Movie | Setting 3 |
| ... | ... |
| Music-classical music | Setting 4 |
| Music- dance music | Setting 5 |
| Music- heavy metal music | Setting 6 |
| ... | ... |

As shown in Table 1, in the case where the genre determiner 110 determines that the genre of the sound data is a news program, the equalizer setter 120 sets the equalizer as Setting 1, and in the case where the genre determiner 110 determines that the genre of the sound data is a classical music as a music program, the equalizer setter 120 sets the equalizer as Setting 4.

The reproducer 130 reproduces the sound data based on the set equalizer.

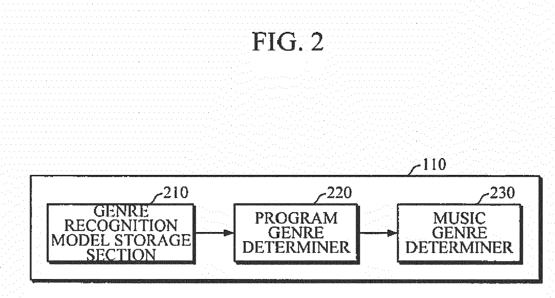

FIG. 2 is a block diagram illustrating an example of a genre determiner 110 illustrated in FIG.1.

Referring to FIG. 2, the genre determiner 110 includes the following structural processors: a genre recognition model storage section 210, a program genre determiner 220, and a music genre determiner 230.

The genre recognition model storage section 210 stores a genre recognition model. In an embodiment, the genre recognition model is pre-generated by machine learning by using training sound data or by using a rule-base algorithm using hand-crafted features. Examples of the machine learning algorithm may include, but are not limited to, neural network, decision tree, generic algorithm (GA), genetic programming (GP), Gaussian process regression, Linear Discriminant Analysis, K-nearest Neighbor (K-NN), Perceptron, Radial Basis Function Network, Support Vector Machine (SVM), and deep-learning.

The genre recognition model storage section 210 includes at least one storage medium among flash memory type, hard disk type, multi-media card micro type, card type memory (e.g., SD or XD memory, etc.), random access memory (RAM), static random access memory (SRAM), read-only memory (ROM), electrically erasable programmable read only memory (EEPROM), programmable read only memory (PROM), magnetic memory, magnetic disks, and optical discs.

Although the genre recognition model storage section 210 is included in the genre determiner 110 in FIG. 1, the genre recognition model storage section 210 is not limited thereto. In other words, the genre recognition model storage section 210 may be positioned in the genre determiner 110 or as an external element of the genre determiner 110.

The program genre determiner 220 is a processor configured to determine a program genre of the sound data based on the genre recognition model. In other words, the program genre determiner 220 determines a program genre (such as, news, drama, entertainment, sport, documentaries, movie, comedy, music, etc.) of the sound data.

In response to the program genre determiner 220 determining that the sound data is a music program, such as, music data, the music genre determiner 230 determines a music genre of the sound data based on the genre recognition model. In other words, the music genre determiner 230 determines a music genre, such as, classical, dance, folk, heavy metal, hip-hop, jazz, pop, rock, Latin, ballad, rap, etc. of the sound data.

In an example, the determination of the program genre made by the program genre determiner 220 and the determination of the music genre made by the music genre determiner 230 are performed independently and sequentially, but the determinations are not limited thereto and may be performed simultaneously or at the same time by using one genre recognition model.

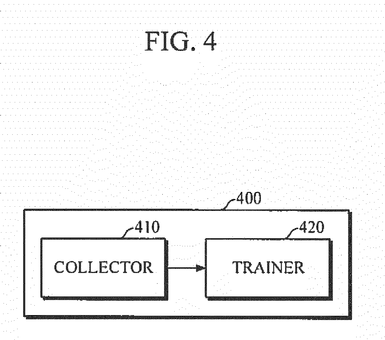

As described above, the genre recognition model is an integrated model that is trained (by a trainer 420, to be later described in FIG. 4, for example) to determine the program genre and the music genre, at the same time. The genre recognition model is an integrated model as it may be divided into a program genre recognition model and a music genre recognition model, which are trained independently from each other or are trained simultaneously. The program genre recognition model is a model trained to determine a program genre, and the music genre recognition model is a model trained to determine a music genre. In this example, the program genre determiner 220 determines a program genre of sound data by using the program genre recognition model, and the music genre determiner 230 determines a music genre of sound data by using the music genre recognition model.

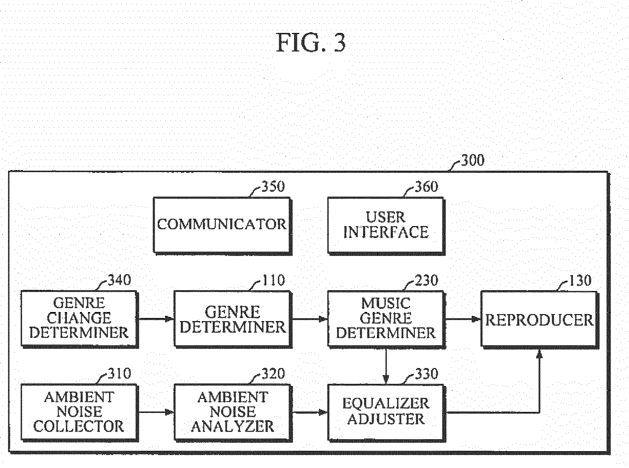

FIG. 3 is a block diagram illustrating another example of an apparatus to control sound, according to an embodiment.

Referring to FIG. 3, the apparatus 300 to control sound (hereinafter referred to as sound controlling apparatus) includes an ambient noise collector 310, an ambient sound analyzer 320, an equalizer adjuster 330, a genre change determiner 340, a communicator 350, and a user interface 360, in addition to the genre determiner 110, the reproducer 130 illustrated and described with respect to FIG. 1, and the music genre determiner 230 illustrated and described with respect to FIG. 2.

The ambient noise collector 310 is a processor configured to collect ambient noise from an environment, such as, a subway, a house, a school, an airport, etc., where sound data is produced. To this end, the ambient noise collector 310 may include a microphone.

The ambient noise analyzer 320 analyzes the collected ambient noise. For example, the ambient noise analyzer 320 analyzes a frequency component of the collected ambient noise by using a Fast Fourier Transform (FFT) algorithm.

The equalizer controller 330 adjusts the setting of the equalizer, set by the equalizer setter 120 (as described and illustrated in FIG. 2), based on a result of analysis performed by the ambient noise analyzer 320. In an embodiment, the equalizer adjuster 330 adjusts the setting of the equalizer, set by the equalizer setter 120, to minimize the effect of ambient noise. For example, in the case where the analysis of a frequency component of ambient noise shows that a specific ambient frequency component is high, the equalizer adjuster 330 may adjust the set equalizer to attenuate the specific ambient frequency component.

In accordance with an embodiment, the sound controlling apparatus 300 increases the Signal to Noise Ratio (SNR) in the entire frequency range.

The genre change determiner 340 determines whether a genre has changed by analyzing, in advance, data to be reproduced while sound data is reproduced. In an embodiment, the genre change determiner 340 analyzes a frequency component of the data to be reproduced while the sound data is reproduced by using a FFT algorithm. For example, upon analyzing a frequency component of the data to be reproduced while the sound data is reproduced, the genre change determiner 340 determines that a genre has changed in response to a specific frequency component being changed to a level above a predetermined threshold.

Once the genre change determiner 340 determines that the genre has changed while the sound data is being reproduced, the genre determiner 110 re-determines a genre of sound data based on the data to be reproduced, the equalizer setter 120 resets the equalizer according to the re-determined genre, and the reproducer 130 reproduces the sound data based on reset equalizer, starting from data subsequent to data of which the genre is changed.

In this manner, the sound controlling apparatus 300 changes the setting of the equalizer while sound data is reproduced, according to the changed genre of sound data.

The communicator 350 communicates with external devices. For example, the communicator 350 transmits or receives sound data to and from external devices.

In accordance with an embodiment, the external device is a server that stores sound data, a sound reproducing apparatus that reproduces sound data, or a display that displays various types of information related to sound data. In addition, examples of the external device may include, but are not limited to, a smartphone, a cellular phone, a personal digital assistant (PDA), a laptop computer, a personal computer (PC), a digital TV, a smart TV, or other mobile or non-mobile computing devices.

The communicator 350 communicates with external devices by using Bluetooth communication, Bluetooth Low Energy communication, Near Field Communication (NFC), WLAN communication, Zigbee communication, Infrared Data Association (IrDA) communication, Wi-Fi Direct (WFD) communication, Ultra-Wideband (UWB) communication, Ant+ communication, Wi-Fi communication, Radio Frequency Identification (RFID) communication, and the like. Further, the communicator 350 may include a tuner that receives broadcasting programs, and may receive sound data through the tuner. However, the communicator 350 is merely illustrative, and is not limited thereto.

The user interface 360 is an interface between the sound controlling apparatus 300 and a user and/or other external devices, and may include an input wired or wireless port and an output wired or wireless port.

Information needed to operate the sound controlling apparatus 300 is input through the user interface 360, and a result of setting the equalizer is output through the user interface 360. The user interface 360 includes, for example, a button, a connector, a keypad, a display, and other similar input or interface devices.

FIG. 4 is a block diagram illustrating an example of an apparatus to train a genre recognition model on sound data, according to an embodiment. The apparatus 400 to train a genre recognition model may be an apparatus that trains a genre recognition model for the sound controlling apparatuses 100 and 300.

Referring to FIG. 4, the apparatus 400 to train a genre recognition model includes a collector 410 and a trainer 420.

The collector 410 is a processor configured to collect a plurality of training sound data. In this example, the plurality of training sound data is data classified according to a program genre and a music genre. Examples of the program genre may include, but are not limited to, news, drama, entertainment, sport, documentaries, movie, comedy, music, and the like, and examples of the music genre may include, but is not limited to, classical, dance, folk, heavy metal, hip hop, jazz, pop, rock, Latin, ballad, and rap.

The trainer 420 trains a genre recognition model by machine learning based on the plurality of training sound data. Examples of the machine learning algorithm may include, but are not limited to, neural network, decision tree, generic algorithm (GA), genetic programming (GP), Gaussian process regression, Linear Discriminant Analysis, K-nearest Neighbor (K-NN), Perceptron, Radial Basis Function Network, Support Vector Machine (SVM), and deep-learning.

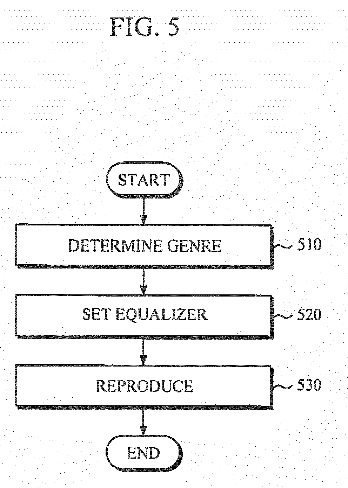

FIG. 5 is a flowchart illustrating an example of a method to control sound, according to another embodiment.

Referring to FIGS. 1 and 5, at operation 510, the sound controlling apparatus 100 determines a genre of the input sound data.

For example, the sound controlling apparatus 100 determines a genre of the sound data by analyzing metadata related to the sound data or by using a genre recognition model, in which in an example in which the sound data is music data, the sound controlling apparatus 100 determines a music genre of the sound data. Examples of the program genre may include, but are not limited to, news, drama, entertainment, sport, documentaries, movie, comedy, and music, and examples of the music genre may include, but are not limited to, classical, dance, folk, heavy metal, hip hop, jazz, pop, rock, Latin, ballad, and rap.

The genre recognition model may be pre-generated by machine learning based on the plurality of training sound data or by using a rule-base algorithm using hand-craft features. Examples of the machine learning algorithm may include, but are not limited to, neural network, decision tree, generic algorithm (GA), genetic programming (GP), Gaussian process regression, Linear Discriminant Analysis, K-nearest Neighbor (K-NN), Perceptron, Radial Basis Function Network, Support Vector Machine (SVM), and deep-learning.

The sound controlling apparatus 100 determines the genre of sound data in real time based on part of the entire sound data in response to an instruction to reproduce the sound data. For instance, in an example in which the sound data is a file data or streaming data, upon receiving the instruction to reproduce the sound data, the sound controlling apparatus 100 determines the genre of the sound data based on the initial five-second part of the entire sound data.

At operation 520, the sound controlling apparatus 100 sets an equalizer according to the determined genre of the sound data. For example, the sound controlling apparatus 100 sets the equalizer by using a mapping table shown in Table 1.

Subsequently, at operation 530, the sound controlling apparatus 100 reproduces sound data based on the set equalizer.

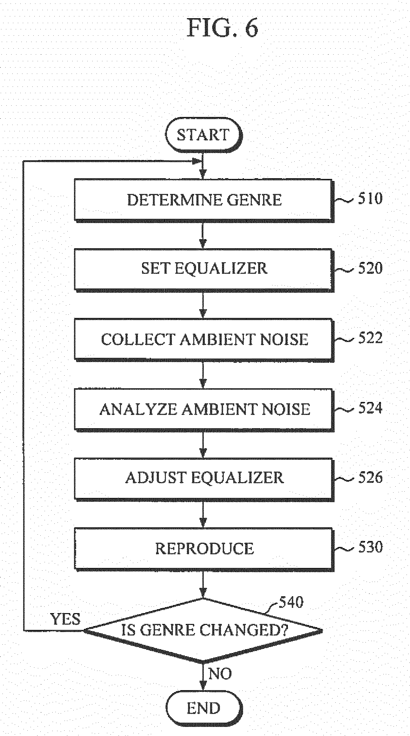

FIG. 6 is a flowchart illustrating another example of a method to control sound, according to another embodiment.

The method to control sound in FIG. 6 includes operations 510 through 530 illustrated and described with respect to FIG. 5. In addition, between operations 520 and 530, at operation 522, the method collects ambient noise, at operation 524, analyzes the ambient noise, and at operation 526, adjusts the equalizer. At operation 540, the method determines whether a genre is changed in 540 selectively in addition to the method to control sound in FIG. 5.

Referring to FIGS. 3 and 6, at operation 522, the sound controlling apparatus 300 collects ambient noise from an environment, such as a subway, a house, a school, an airport, etc., where sound data is reproduced.

At operation 524, the sound controlling apparatus 300 analyzes the collected ambient noise. For example, the sound controlling apparatus 300 may analyze a frequency component of the collected ambient noise by using a Fast Fourier Transform (FFT) algorithm.

Subsequently, the sound controlling apparatus 300 adjusts the equalizer, set in operation 520, based on the analyzed ambient noise. In an embodiment, the sound controlling apparatus 300 adjusts the setting of the equalizer set in operation 520, to minimize the effect of ambient noise. For example, in an example in which the analysis of a frequency component of ambient noise shows that a specific frequency component is high, the sound controlling apparatus 300 adjusts the set equalizer to attenuate the specific frequency component.

At operation 540, the sound controlling apparatus 300 determines whether a genre is changed by analyzing in advance data to be reproduced while sound data is reproduced. In an embodiment, the sound controlling apparatus 300 analyzes a frequency component of data to be reproduced while the sound data is reproduced by using a FFT algorithm, and determines whether a genre is changed based on the analysis.

In response to the determination in operation 540 that a genre is changed, the sound controlling apparatus 300 returns to operation 510 to re-determine a genre of the sound data based on the data to be reproduced.

In this manner, the sound controlling apparatus 300 effectively changes the setting of the equalizer while sound data is reproduced, according to the changed genre of sound data.

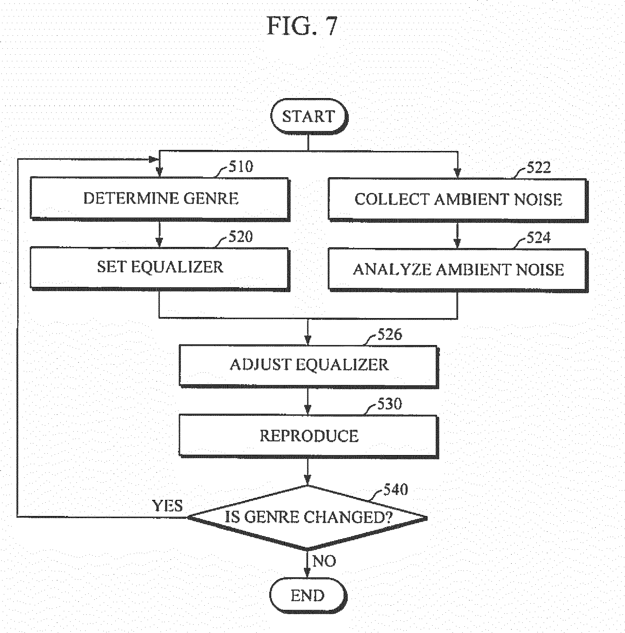

FIG. 7 is a flowchart illustrating yet another example of a method to control sound, according to another embodiment.

Referring to FIGS. 6 and 7, in the method to control sound in FIG. 7, the collecting of ambient noise in operation 522 and the analysis of the ambient noise in operation 524 are performed in parallel or simultaneously with the determination of a genre in operation 510 and the setting of the equalizer in operation 520.

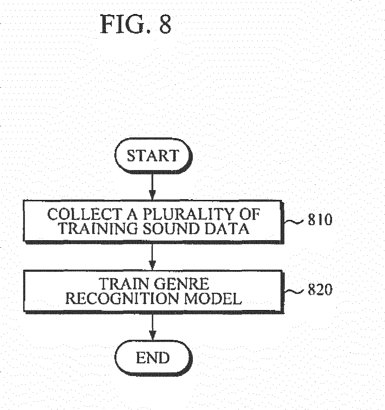

FIG. 8 is a block diagram illustrating an example of a method to train a genre recognition model on sound data, according to an embodiment.

Referring to FIGS. 4 and 8, in operation 810, the apparatus 400 to train a genre recognition model collects a plurality of training sound data, in which the plurality of training sound data may be classified according to a program genre and a music genre. Examples of the program genre may include, but are not limited to, news, drama, entertainment, sport, documentaries, movie, comedy, music, and the like, and examples of the music genre may include, but is not limited to, classical, dance, folk, heavy metal, hip hop, jazz, pop, rock, Latin, ballad, and rap.

In operation 820, the apparatus 400 for training a genre recognition model trains a genre recognition model by machine learning based on the plurality of training sound data. Examples of the machine learning algorithm may include, but are not limited to, neural network, decision tree, generic algorithm (GA), genetic programming (GP), Gaussian process regression, Linear Discriminant Analysis, K-nearest Neighbor (K-NN), Perceptron, Radial Basis Function Network, Support Vector Machine (SVM), and deep-learning.

The genre determiner 110, the equalizer setter 120, the reproducer 130, the genre recognition model storage section 210, the program genre determiner 220, the music genre determiner 230, the ambient noise collector 310, the ambient noise analyzer 320, the equalizer adjuster 330, the genre change determiner 340, the communicator 350, the collector 410, and the trainer 420 in FIGS. 1-4 that perform the operations described in this application are implemented by hardware components configured to perform the operations described in this application that are performed by the hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 5-8 that perform the operations described in this application are performed by computing hardware, for example, by one or more processors or computers, implemented as described above executing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions in the specification, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access memory (RAM), flash memory, CD-ROMs, CD-Rs, CD+Rs, CD-RWs, CD+RWs, DVD-ROMs, DVD-Rs, DVD+Rs, DVD-RWs, DVD+RWs, DVD-RAMs, BD-ROMs, BD-Rs, BD-R LTHs, BD-REs, magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims.

## Claims

1. A method of controlling sound, the method comprising:
determining a genre of sound data by using a genre recognition model;
setting an equalizer according to the determined genre; and
reproducing the sound data based on the set equalizer.

2. The method of claim 1, wherein the determining of the genre comprises determining a program genre of the sound data, and determining a music genre of the sound data in response to a determination that the sound data is music data.

3. The method of claim 1 or 2, wherein the program genre comprises at least one of news, drama, entertainment, sport, documentaries, movie, comedy, and music, and/or wherein the music genre comprises at least one of classical, dance, folk, heavy metal, hip hop, jazz, pop, rock, Latin, ballad, and rap.

4. The method of one of claims 1 to 3, wherein the genre recognition model is generated by machine learning based on training sound data, and
wherein the machine learning algorithm comprises one of neural network, decision tree, generic algorithm, GA, genetic programming, GP, Gaussian process regression, Linear Discriminant Analysis, K-nearest Neighbor, K-NN, Perceptron, Radial Basis Function Network, Support Vector Machine, SVM, and deep-learning.

5. The method of one of claims 1 to 4, wherein the determining of the genre comprises determining the genre of the sound data partially based on the entire sound data.

6. The method of one of claims 1 to 5, further comprising determining whether the genre has changed by analyzing in advance data to be reproduced while the sound data is reproduced, and
further comprising re-determining the genre of the sound data based on the data to be reproduced, in response to the determination that the genre has changed.

7. The method of one of claims 1 to 6, further comprising collecting ambient noise from an environment where the sound data is reproduced;
analyzing the collected ambient noise; and adjusting the set equalizer based on the analysis, and
wherein the adjusting of the set equalizer comprises adjusting the set equalizer to minimize an effect of the collected ambient noise.

8. Computer- readable medium having instructions that, when performed by a processor, cause the processor to perform method to train a genre recognition model on sound data for a sound controlling apparatus, the method comprising:
collecting training sound data, which are classified according to a program genre and a music genre; and
training the genre recognition model based on the collected training sound data.

9. The computer-readable medium of claim 8, wherein the program genre comprises at least one of news, drama, entertainment, sport, documentaries, movie, comedy, and music, and/or
wherein the music genre comprises at least one of classical, dance, folk, heavy metal, hip hop, jazz, pop, rock, Latin, ballad, and rap.

10. The computer-readable medium of claim 8 or 9, wherein a learning algorithm comprises one of neural network, decision tree, generic algorithm, GA, genetic programming, GP, Gaussian process regression, Linear Discriminant Analysis, K-nearest Neighbor, K-NN, Perceptron, Radial Basis Function Network, Support Vector Machine, SVM, and deep-learning.

11. An apparatus, comprising:
a genre determiner configured to determine a genre of input sound data by analyzing metadata of the sound data or by using a genre recognition model to determine either one or both of a program genre of the sound data and, in response to the sound data being music data, a music genre of the sound data;
an equalizer setter configured to process a mapping table that maps the genre of the sound data to a preset setting to set an equalizer; and
a reproducer configured to reproduce the sound data.

12. The apparatus of claim 11, wherein the genre determiner determines the genre of the sound data in real time, or
wherein the genre determiner determines either the one or both of the program genre and the music genre independently and sequentially, or simultaneously.

13. The apparatus of claim 11 or 12, wherein the metadata comprises content properties of the sound data comprising information on location and details of contents, information on a content writer, or information on genre of contents.

14. The apparatus of one of claims 11 to 13, wherein the apparatus is configured to increase Signal to Noise Ratio, SNR, in the entire frequency range.

15. The apparatus of one of claims 11 to 14, further comprising:
an ambient noise collector configured to collect ambient noise from an environment where the sound data is reproduced,
an ambient noise analyzer configured to analyze the collected ambient noise, and
an equalizer controller configured to adjust the setting of the equalizer based on a result of the analysis performed by the ambient noise analyzer to minimize an effect of ambient noise, or
further comprising:
a genre change determiner configured to determine whether a genre has changed by analyzing, in advance, data to be reproduced while the sound data is reproduced and, upon analyzing a frequency component of the data to be reproduced while the sound data is reproduced, determine that a genre has changed in response to a specific frequency component being changed to a level above a predetermined threshold.
